## Europäisches Patentamt
## European Patent Office
## Office européen des brevets

(19)

(11) Veröffentlichungsnummer: **0 015 252**
**B1**

(12)

# EUROPÄISCHE PATENTSCHRIFT

(45) Veröffentlichungstag der Patentschrift:
**01.12.82**

(21) Anmeldenummer: **80890023.7**

(22) Anmeldetag: **26.02.80**

(51) Int. Cl.³: **C 23 C 11/10** // C01B31/02,
G21C3/62

(54) **Verfahren zur Abscheidung von Kohlenstoffschichten.**

(30) Priorität: **26.02.79 AT 1469/79**

(43) Veröffentlichungstag der Anmeldung:
**03.09.80 Patentblatt 80/18**

(45) Bekanntmachung des Hinweises auf die Patenterteilung:
**01.12.82 Patentblatt 82/48**

(84) Benannte Vertragsstaaten:
**BE DE FR GB**

(56) Entgegenhaltungen:
**AT-B-328574**
**GB-B-286845**
**US-A-3472677**

(73) Patentinhaber: **Österreichisches Forschungszentrum Selbersdorf Gesellschaft m.b.H., Lenaugasse 10, A-1082 Wien (AT)**

(72) Erfinder: **Kofler, Othmar, Heldenplatz 1, A-2440 Reisenberg (AT)**

## Verfahren zur Abscheidung von Kohlenstoffschichten

Die Erfindung bezieht sich auf ein Verfahren zur Abscheidung von zusammenhängenden Kohlenstoffschichten auf hochtemperaturempfindlichen Gegenständen, gegebenenfalls auf in einem Wirbelbett befindlichen Teilchen, insbesondere aus toxischem und/oder radioaktivem Material, durch Zerlegen eines zumindestens einen gasförmigen, ungesättigten Kohlenwasserstoff mit zwei oder drei Kohlenstoffatomen enthaltenden gasförmigen Mediums, insbesondere von Acetylen.

Es ist bekannt, Gegenstände, z.B. kugelförmige Teilchen aus toxischen Abfällen, radioaktiven Abfällen, Kernbrennstoffen und dgl. in einem Wirbelbett durch thermische Zersetzung von Kohlenwasserstoffen bei erhöhter Temperatur zu beschichten. Aus der AT-PS Nr. 333389 ist ein Verfahren zur mehrfachen Beschichtung von Metalloxiden bekannt, wobei die kugelförmigen Metalloxide bei einer Temperatur von 1350° C in der Wirbelschicht durch pyrolytische Zersetzung von Methan mit einer ersten, dichten Schichte aus Pyrokohlenstoffumhüllt werden. Sodann wird die Temperatur bei aufrechterhaltener Methanzufuhr auf 1400° C erhöht, wobei eine weitere, jedoch poröse, Schichte aus Pyrokohlenstoff ablagert wird. Sodann wird die Temperatur auf 1900° C gesteigert, wobei nunmehr aus der methanhaltigen Gasatmosphäre eine hochdichte Schichte aus isotropen Pyrokohlenstoff auf die Teilchen abschieden wird.

In der AT-PS Nr. 328574 wird ein Verfahren zur Beschichtung von Brennstoffteilchen beschrieben, bei dem in einer ersten Stufe in einem Wirbelbett bei 1000° C aus acetylenhältigen Helium, wobei das Helium als Trägergas dient, eine schwammige Schichte aus pyrolytischem Kohlenstoff abgeschieden wurde. Sodann wird die Temperatur auf 1450° C erhöht und die Zugabe von Acetylen durch Propan ersetzt, wodurch eine Schicht aus isotropem, pyrolytischem Kohlenstoff abgeschieden wird.

Sowohl die porösen oder schwammigen Schichten als auch die dichten Schichten aus Pyrokohlenstoff sind von technischer Bedeutung. In den porösen Schichten können Spaltstoffe, entstehende Gase oder dgl. abgelagert werden, wohingegen die dichte Schichte eine Umhüllung bildet, die ein Austreten von Schadstoffen verhindert.

Nachteilig bei den bekannten Verfahren zur Beschichtung mit Pyrokohlenstoff ist die relativ hohe Temperatur, welche im Wirbelbett herrschen muss. Durch diese hohe Temperatur können einerseits Stoffe, die bei diesen hohen Temperaturen einen hohen Gasdruck aufweisen, nicht mehr beschichtet werden, andererseits ist die Abnutzung der Apparatur bei höheren Temperaturen stärker gegeben und die Abgasprobleme schwieriger zu beherrschen.

Die mit Pyrokohlenstoff beschichteten Teile sind auch für die Humanmedizin von Bedeutung, wie beispielsweise für die Herstellung künstlicher Zahnwurzeln, Herzklappenventile, Gelenke und

dgl. Auch hier wirkt es sich nachteilig aus, dass eine Beschichtung mit Pyrokohlenstoff nach den bisher bekannten Verfahren nur bei hohen Temperaturen durchgeführt werden kann, so dass die zu beschichtenden Gegenstände hochtemperaturbeständig sein müssen, obwohl diese Eigenschaft bei ihrer Verwendung innerhalb des menschlichen Körpers vollkommen ohne Bedeutung ist und lediglich eine schwierigere und kostenaufwendigere Herstellung der zu beschichtenden Teile bedingt.

Ziel der vorliegenden Erfindung ist ein Verfahren zu schaffen, das die obenangeführten Nachteile nicht aufweist und welches erlaubt, zusammenhängende, mechanisch entsprechend widerstandsfähige Kohlenstoffschichten auch bei niedrigen Temperaturen abzuscheiden.

Das erfindungsgemässe Verfahren zur Abscheidung von zusammenhängenden, mechanisch widerstandsfähigen Kohlenstoffschichten bei vergleichsweise niederer Temperatur, gegebenenfalls auf in einem Wirbelbett befindlichen Teilchen, aus einem zumindest einen gasförmigen, ungesättigten Kohlenwasserstoff mit zwei bis drei Kohlenstoffatomen enthaltenden gasförmigen Medium, besteht im wesentlichen darin, dass dem gasförmigen Medium Wasserstoff und ein bereits bei Temperaturen unter der Abscheidungstemperatur der Kohlenstoffschicht gasförmiges Metallcarbonyl oder eine Mischung derartiger Metallcarbonyle derselben zugegeben wird. Durch den Zusatz der Metallcarbonyle und des Wasserstoffes kann die Abscheidung von Pyrokohlenstoffschichten bereits bei Temperaturen wesentlich unter 1000° C erreicht werden, so dass ein wesentlich leichter handhabbareres Verfahren geschaffen ist, bei dem auch Teile beschichtet werden können, die nicht hochtemperaturbeständig sind. Weiters kann die Apparatur, in welcher die Beschichtung durchgeführt wird, einfacher gehalten sein, da keine Hochtemperaturbeanspruchungen auftreten.

Gemäss einem weiteren Merkmal der Erfindung werden die monomolekularen Carbonyle der achten Nebengruppe des Periodensystems der Elemente, vorzugsweise das Nickeltetracarbonyl und das Eisenpentacarbonyl verwendet. Die monomolekularen Typen, also auch das Rutheniumpentacarbonyl und das Osmiumpentacarbonyl weisen auch bei relativ niedrigen Temperaturen noch einen derartig hohen Dampfdruck auf, dass eine Zugabe zum gasförmigen Medium besonders leicht durchgeführt werden kann. Bei der Verwendung von Eisenpentacarbonyl bzw. Nickeltetracarbonyl kann auf eine Aufarbeitung der gleichzeitig mit der Abscheidung der Kohlenstoffschichten anfallenden Russteilchen und dgl. aus wirtschaftlichen Gründen verzichtet werden. Wird ein Carbonyl von Ruthenium oder Osmium verwendet, so wird aus wirtschaftlichen Gründen eine entsprechende Aufarbeitung in der Regel erforderlich sein.

Vorzugsweise werden dem gasförmigen Medium zwischen 0,1 und 3,0 Gew.% Carbonyle zugesetzt, bezogen auf den gasförmigen ungesättigten Kohlenwasserstoff. Innerhalb dieser Grenzen ist die katalytische Wirksamkeit besonders gut, wobei der Metallgehalt der abgeschiedenen Pyrokohlenstoffschichte noch sehr gering gehalten ist.

Wird gemäss einem weiteren Merkmal des erfindungsgemässen Verfahrens dem gasförmigen Medium Wasserstoff zugesetzt, so wird eine besonders gleichförmige, zusammenhängende, mechanisch entsprechend widerstandsfähige Pyrokohlenstoffschicht abgeschieden, gleichzeitig wird eine wesentliche Erhöhung der Abscheiderate erzielt. Es können Schichten mit unterschiedlichen Strukturen und Dichten hergestellt werden.

Als bevorzugter Temperaturbereich für die erfindungsgemässe Abscheidung durch pyrolytische Zersetzung haben sich die Temperaturen zwischen 250 und 700° C erwiesen, da bereits in diesem niederen Temperaturenbereich Beschichtungen erhalten werden, die allen Anforderungen genügen und die den technologischen Vorteil des erfindungsgemässen Verfahrens besonders deutlich werden lassen.

Im folgenden wird die Erfindung anhand von Beispielen näher erläutert.

Für alle Beispiele wurde die gleiche Wirbelschichtanlage verwendet. Die Wirbelschichtanlage wies ein Reaktionsrohr aus Graphit auf, welches zur Einhaltung einer bestimmten Temperatur im Reaktionsraum von einem Heiz- und einem Kühlsystem umgeben war, und an dessen unterem Ende sich eine Düsenplatte für die Zufuhr des Gasgemisches befand. Am oberen Ende wurde das Abgas samt Nebenprodukten über eine eigene Rohrleitung einer chemischen und physikalischen Reinigungsanlage zugeführt. Dem Trägergasstrom konnten über ein Mischventil die gasförmigen Kohlenwasserstoffe und weitere Gase zugefügt werden, insbesondere Wasserstoff und die gasförmigen oder verdampften Metallcarbonyle. Die Dosierung der Metallcarbonyle erfolgte derart, dass diese in einem auf konstanter Temperatur gehaltenen mit der Trägergasleitung verbundenen Behälter angeordnet waren, so dass entsprechend dem in dem Behälter herrschenden Gasdruck der Carbonyle diese in den Trägergasstrom gelangten.

*Beispiel 1*

In den Reaktionsraum wurden 11 g poröse, kugelförmige Kohlenstoffteilchen mit einem Durchmesser von ca. 540 µm eingebracht, die ein Schüttvolumen von 30,8 cm³ aufwiesen, und mit einem Gasstrom fluidisiert, der 0,1 Gew.% Nickeltetracarbonyl, 1,06 l/min Argon, 1,60 l/min Wasserstoff und 0,25 l/min Acetylen enthält. Es wurde eine Temperatur von 480° C während 120 min aufrecht erhalten, wonach der Beschichtungsvorgang beendet wurde. Die Teilchen wiesen eine Gewichtszunahme von 10,5 g auf und waren von einer glatten dunkelgrauen gut haftenden Schichte aus Kohlenstoff umhüllt. Die Schichte wies 1,0 Gew.% Nickel auf.

*Beispiel 2*

Unter Einhaltung der in Beispiel 1 angegebenen Bedingungen, jedoch ohne Zufuhr von Nickeltetracarbonyl wurde keine Zunahme des Teilchengewichtes beobachtet.

*Beispiel 3*

11 g der in Beispiel 1 angegebenen Teilchen wurden mit einem Gasstrom fluidisiert, der 0,2 Gew.% Nickeltetracarbonyl, 2,50 l/min Argon, 1,20 l/min Wasserstoff und 0,50 l/min Acetylen enthielt. Es wurde eine Temperatur von 250° C eingehalten. Nach 75 min wurde der Beschichtungsvorgang unterbrochen und die Teilchen ausgewogen. Es konnte eine Gewichtszunahme um 2,4 g festgestellt werden. Die Teilchen wiesen eine stark strukturierte dunkelgraue gut haftende Schicht auf. In der Schicht konnten Spuren von Nickel nachgewiesen werden.

*Beispiel 4*

Unter Einhaltung der in Beispiel 3 angegebenen Bedingungen, jedoch ohne Zugabe von Nickeltetracarbonyl wurde keine Zunahme des Teilchengewichtes beobachtet.

*Beispiel 5*

11 g der in Beispiel 1 angegebenen Teilchen wurden mit einem Gasstrom fluidisiert, der 1,5 Gew.% Nickeltetracarbonyl, 1,20 l/min Argon, 1,30 l/min Wasserstoff und 0,81 l/min Äthen enthielt. Die Beschichtung dauerte 120 min und es wurde eine Temperatur von 509° C eingehalten. Die Gewichtszunahme betrug 4,5 g. Die Teilchen wiesen eine glänzende, glatte Kohlenstoffbeschichtung auf, die 0,86 Gew.% Nickel enthielt. Das aus dem Reaktionsraum abgeleitete Gas war besonders arm an Russ und wies keinen Rauch auf, wie er üblicherweise bei der Abscheidung von Kohlenstoffschichten mittels Acetylen bekannt ist.

*Beispiel 6*

Unter Einhaltung der in Beispiel 5 angegebenen Bedingungen, jedoch ohne Zufuhr von Nickelcarbonyl konnte keine Abscheidung einer Kohlenstoffschichte beobachtet werden.

*Beispiel 7*

11 g der in Beispiel 1 angegebenen Teilchen wurden mit einem Gasstrom fluidisiert, der 3 Gew.% Nickeltetracarbonyl, 1,20 l/min Argon, 1,60 l/min Wasserstoff und 0,60 l/min Propen enthielt. Die Beschichtung dauerte 120 min bei 450° C, die Gewichtszunahme betrug 3,7 g. Die Teilchen wiesen eine glänzende, graue, leicht strukturierte Kohlenstoffschichte auf, die 1,05 Gew.% Nickel enthielt. Das aus dem Reaktionsraum abgeleitete Gas war arm an Russ.

*Beispiel 8*

Unter Einhaltung der in Beispiel 7 angegebenen Bedingungen, jedoch ohne Zufuhr von Nickeltetracarbonyl konnte keine Abscheidung einer Kohlenstoffschichte beobachtet werden.

*Beispiel 9*

11 g der in Beispiel 1 beschriebenen Teilchen wurden mit einem Gasstrom, der 1,0 Gew.% Eisenpentacarbonyl, 1,20 l/min Argon, 2,5 l/min Wasserstoff und 0,5 l/min Acetylen enthielt, bei 450° C fluidisiert. Die Beschichtung dauerte 120 min und die Gewichtszunahme der Teilchen betrug hiebei 2,0 g. Die Teilchen wiesen eine strukturierte Kohlenstoffschichte auf, die 0,75 Gew.% Eisen enthielt. Das aus dem Reaktionsraum abgeleitete Gas war arm an Russ und wies keinen Rauch auf.

*Beispiel 10*

Unter Einhaltung der in Beispiel 9 angegebenen Bedingungen, jedoch ohne Zufuhr von Eisenpentacarbonyl konnte keine Abscheidung einer Kohlenstoffschichte beobachtet werden.

*Beispiel 11*

In den Reaktionsraum wurden 40 g kugelförmige Glaskörper mit einem Durchmesser von etwa 0,7 mm gebracht, die ein Schüttvolumen von 23 cm² aufwiesen, und mit einem Gasstrom fluidisiert, der 1,7 Gew.% Nickeltetracarbonyl, 5,5 l/min Argon, 2,9 l/min Wasserstoff und 0,45 l/min Acetylen enthielt. Es wurde eine Temperatur, von 450° C während 180 min aufrecht erhalten, wonach der Beschichtungsvorgang beendet wurde. Die Teilchen wiesen eine Gewichtszunahme von 4,6 g auf.

*Beispiel 12*

Unter Einhaltung der in Beispiel 11 angegebenen Bedingungen, wobei jedoch statt Wasserstoff die gleiche Menge an Argon zusätzlich zugesetzt wurde, wurden nur 0,5 g Kohlenstoffbeschichtung abgeschieden. Die abgeschiedene Schicht war von geringerer Qualität, insbesondere in Hinblick auf die mechanische Festigkeit und die Dichte.

*Beispiel 13*

Unter Einhaltung der in Beispiel 11 angegebenen Bedingungen, jedoch ohne Zufuhr von Nikeltetracarbonyl konnte keine Abscheidung einer Kohlenstoffschicht beobachtet werden.

## Patentansprüche

1. Verfahren zur Abscheidung von zusammenhängenden Kohlenstoffschichten auf hochtemperaturempfindlichen Gegenständen, gegebenenfalls auf in einem Wirbelbett befindlichen Teilchen, insbesondere aus toxischem und/oder radioaktivem Material, durch Zerlegen eines zumindestens einen gasförmigen, ungesättigten Kohlenwasserstoff mit zwei oder drei Kohlenstoffatomen enthaltenden gasförmigen Mediums, insbesondere Acetylen, dadurch gekennzeichnet, dass dem gasförmigen Medium zumindestens ein bereits bei Temperaturen unterhalb der Abscheidungstemperatur der Kohlenstoffschichte gasförmiges Metallcarbonyl und Wasserstoff zugesetzt wird, und dass bei der Abscheidung der Kohlenstoffschicht Temperaturen zwischen 250° C und 700° C eingehalten werden.

2. Verfahren nach Anspruch 1, dadurch gekennzeichnet, dass als Metallcarbonyle die monomolekularen Carbonyle der achten Nebengruppe des Periodensystems der Elemente, vorzugsweise Nickeltetracarbonyl oder Eisenpentacarbonyl, verwendet werden.

3. Verfahren nach einem der beiden Ansprüche 1 oder 2, dadurch gekennzeichnet, dass dem gasförmigen Medium zwischen 0,1 und 3,0 Gew.% Carbonyle zugesetzt werden, bezogen auf die Menge des gasförmigen ungesättigten Kohlenwasserstoffes.

## Revendications

1. Procédé pour déposer des couches de carbone cohérentes sur des objets sensibles aux hautes températures, le cas échéant sur des particules se trouvant dans un lit fluidisé, et pouvant être en particulier des particules d'un matériau toxique et/ou radioactif, par décomposition d'un milieu gazeux, contenant au moins un hydrocarbure insaturé à l'état gazeux, avec deux ou trois atomes de carbone, en particulier l'acétylène, caractérisé en ce que l'on ajoute au milieu gazeux de l'hydrogène et au moins un carbonyle métallique se trouvant sous forme gazeuse à des températures inférieures à la température de dépôt de la couche de carbone, et en ce que le dépôt de la couche de carbone s'effectue à une température située entre 250 et 700° C.

2. Procédé selon la revendication 1, caractérisé en ce que les carbonyles métalliques utilisés sont les carbonyles monomoléculaires du huitième groupe auxiliaire du système périodique des éléments, préférentiellement le nickelcarbonyle ou le pentacarbonyle de fer.

3. Procédé selon l'une des revendications 1 ou 2, caractérisé en ce que l'on ajoute au milieu à l'état gazeux entre 0,1 et 3,0% en poids de carbonyle, calculés par rapport à l'hydrocarbure insaturé à l'état gazeux.

## Claims

1. A process for the separation of coherent carbon layers on high temperature sensitive objects, including particles in a fluidized bed, consisting in particular of toxis and/or radioactive material, by decomposition of a gaseous medium containing at least one gaseous unsaturated hydrocarbon with two or three carbon atoms, particularly acetylene, characterized by the fact that at least one metal cabonyl, entering into the gaseous state at temperatures below the separation temperature of the carbon layer, and hydrogen are added to the gaseous medium and that the temperatures required for the separation of the carbon layer are in the 250-700° C range.

2. A process as claimed in claim 1, characterized by the fact that the metal carbonyls used are the monomolecular carbonyls of the eighth group of the periodic system of the elements, preferably nikkel carbonyl or iron pentacarbonyl.

3. A process as claimed in claim 1 or 2, characterized by the fact that carbonyls in the amount of 0,1-3,0 wt-% of the gaseous, unsaturated hydrocarbon are added to the gaseous medium.